# EUROPEAN PATENT APPLICATION

(11) **EP 3 462 480 A1**
(43) Date of publication of application: **03.04.2019**
(21) Application number: 18190857.5
(22) Date of filing: 24.08.2018
(51) Int. Cl.: H01L 23/10, H01L 31/0203

(54) **PACKAGE SEALING STRUCTURE, DEVICE PACKAGE, AND PACKAGE SEALING METHOD**

(30) Priority: 27.09.2017 JP 2017186534
(71) Applicant: Japan Aviation Electronics Industry, Limited, Tokyo 150-0043 (JP)
(72) Inventor: CHIDA, Yasuhiro, Tokyo, 150-0043 (JP)
(74) Representative: MERH-IP Matias Erny Reichl Hoffmann Patentanwälte PartG mbB

(57) **Abstract**

A package sealing structure is provided wherein a narrow neck of a through-hole formed in a package member is closed with substance that has been produced from melting of an outer side of the package member and then has solidified, and the narrow neck is narrower than an opening of the thorough-hole that has been enlarged by the melting.

## Description

### TECHNICAL FIELD

The present invention relates to a package for a device such as an acceleration sensor and, in particular, to a sealing technique for hermetically sealing a package.

### BACKGROUND ART

In a device such as an acceleration sensor that is fabricated using MEMS (Micro Electro Mechanical System) technology, a vacuum is produced in its package in order to maintain the performance of the device or prevent degradation of components in the package. Alternatively, after a vacuum is produced in the package, the package is filled with an inert gas and sealed. For this purpose, a sealing structure for hermetically sealing is provided in the package.

Figs. 1 and 2 illustrate a configuration of a piezoelectric device described in Patent Literature 1 (Japanese Registered Patent No. 4277259) as one example of devices that have such a package sealing structure. A sealing hole 16 of the piezoelectric device is formed by a corner portion of a package frame 13 and a through-hole 15. The package frame 13 forms a mount space 12 for a piezoelectric vibrator 11. The through-hole 15 is provided in a package base 14 in advance. A portion of the through-hole 15 is covered by the corner portion of the package frame 13. A portion of a package member is melted by irradiating an inner wall of the through-hole 15 with a laser beam 17, thereby producing melt 18. The melt 18 covers the sealing hole 16 to seal the mount space 12 for the piezoelectric vibrator 11.

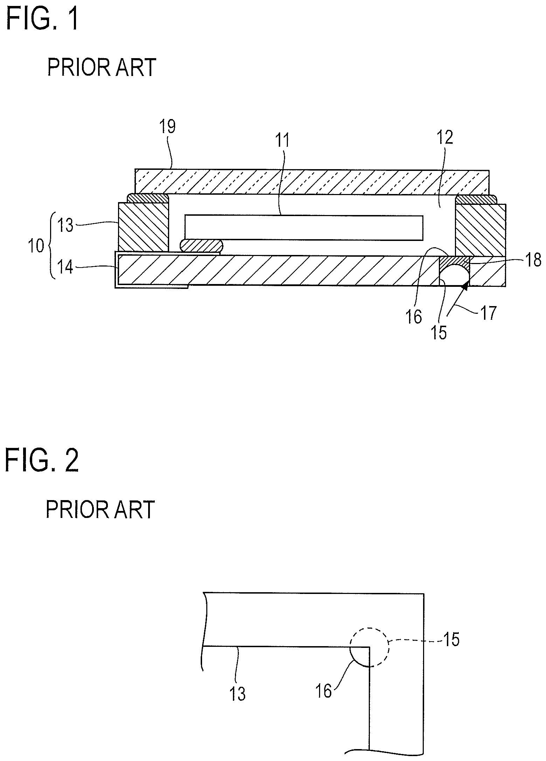

As illustrated in Fig. 2, the center of the through-hole 15 coincides with one corner of the package frame 13. The opening area of the sealing hole 16 is 1/4 of the cross-sectional area of the through-hole 15. The sealing hole 16 which has the opening area smaller than the cross-sectional area of the through-hole 15 formed in the package base 14 is formed by the stack of the package base 14 and the package frame 13.

A lid 19 covers the top opening of a package 10 formed by the package base 14 and the package frame 13. Patent Literature 1 also describes a configuration in which a sealing hole is formed by covering a portion of a through-hole formed in a lid with a corner portion of a package frame 13.

In the package sealing structure of the piezoelectric device described above, the sealing hole is covered by melting a portion of the package member. Accordingly, the method disclosed in Patent Literature 1 is advantageous in terms of parts cost and workability over a method in which a metal ball, which is an additional element, is placed at an opening portion of a hole in a package and the hole is sealed by melting the metal ball with a laser beam. However, formation of the sealing hole by covering the portion of the through-hole by utilizing the corner portion of the package frame requires alignment between the package frame and the package base or the lid in which the thorough hole is formed. Accordingly, the technique in Patent Literature 1 requires additional steps due to the complexity of the fabrication.

Further, the technique in Patent Literature 1 does not allow the location of the sealing hole to be freely chosen because the sealing hole is formed by covering a portion of the through-hole by utilizing a corner portion of the package frame.

### SUMMARY OF THE INVENTION

An object of the present invention is to provide a package sealing technique that is capable of forming a sealing structure in an arbitrary location without the need for any additional element beside packaging members.

In a package sealing structure according to the present invention, a narrow neck of a through-hole formed in a package member is closed with a substance that has been produced from melting of an outer side of the package member and then has solidified and the narrow neck is narrower than an opening of the through-hole that has been enlarged by the melting.

In another aspect, a package sealing structure according to the present invention includes a structure resulting from cooling, in a through-hole which had been formed in an enclosure part of a package and had had a hole diameter not uniform in a through direction of the thorough-hole, melt that had been produced from melting of a portion located on a periphery of an outer side opening of the through-hole and had formed a lump without holes in the process of moving down along an inner wall of the through-hole.

A package sealing method according to the present invention includes a through-hole formation step of forming, in an enclosure part of a package, a through-hole having a hole diameter not uniform in a through direction of the thorough-hole; a melting step of melting a portion located on a periphery of an outer side opening of the through-hole; and a cooling step of cooling, in the through-hole, melt that has produced in the melting step and has formed a lump without holes in the process of moving down along an inner wall of the through-hole.

### EFFECTS OF THE INVENTION

The present invention eliminates the need for an additional element beside package members for sealing a sealing hole. Further, according to the present invention, a sealing structure can be formed in an arbitrary location because alignment between package members for forming the sealing hole is not required.

### BRIEF DESCRIPTION OF THE DRAWINGS

Fig. 1 is a cross-sectional view of a conventional package sealing structure;
Fig. 2 is an enlarged plan view of a main part of the package sealing structure illustrated in Fig. 1;
Fig. 3 is a diagram for explaining an overview of a configuration of an embodiment of a device package according to the present invention;
Fig. 4A is a cross-sectional view illustrating a first example shape of a through-hole to be formed in an embodiment of a package sealing structure according to the present invention;
Fig. 4B is a cross-sectional view illustrating the thorough hole illustrated in Fig. 4A after the through-hole is sealed;
Fig. 5A is a cross-sectional view illustrating a second example shape of a through-hole formed in an embodiment of a package member in a package sealing structure according to the present invention;
Fig. 5B is a cross-sectional view illustrating the through-hole illustrated in Fig. 5A after the through-hole is sealed;
Fig. 6 is a cross-sectional view illustrating a third example shape of a through-hole formed in a package member;
Fig. 7 is a cross-sectional view illustrating a fourth example shape of a through-hole formed in a package member;
Fig. 8 is a cross-sectional view illustrating a fifth example shape of a through-hole formed in a package member;
Fig. 9 is a cross-sectional view illustrating a sixth example shape of a through-hole formed in a package member;
Fig. 10 is a cross-sectional view illustrating a seventh example shape of a through-hole formed in a package member;
Fig. 11 is a cross-sectional view illustrating an eighth example shape of a through-hole formed in a package member;
Fig. 12 is a cross-sectional view illustrating a ninth example shape of a through-hole formed in a package member;
Fig. 13 is a cross-sectional view illustrating a tenth example shape of a through-hole formed in a package member;
Fig. 14 is a cross-sectional view illustrating an eleventh example shape of a through-hole formed in a package member; and
Fig. 15 illustrates a package sealing process flow.

### DETAILED DESCRIPTION

Embodiments of the present invention will be described with reference to the drawings.

### FIRST EMBODIMENT

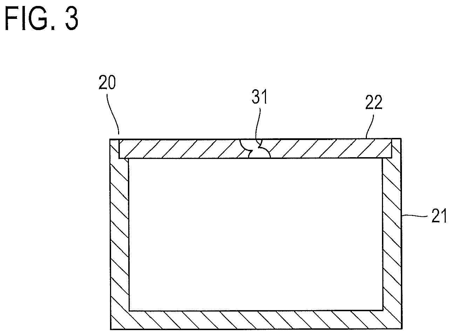

Fig. 3 illustrates an overview of a configuration of a package 20 for an acceleration sensor as an example of a device package. Components enclosed in the package 20 are omitted from Fig. 3.

The package 20 comprises a cylindrical housing 21 with a bottom, which has an opening at an opposite end of the bottom, and a cover 22 which covers the opening of the housing 21. Each of the housing 21 and the cover 22 is made of metal, for example stainless steel. The housing 21 and the cover 22 are joined together by laser welding.

A through-hole 31 to be used for hermetically sealing the package 20 is formed in the center of the cover 22. The through-hole 31 before the hermetic sealing is illustrated in Fig. 3.

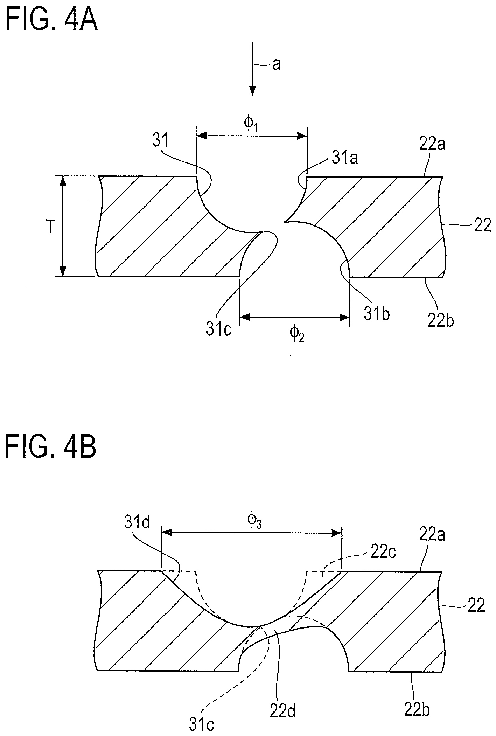

Fig. 4A illustrates the through-hole 31 in detail as a first example. The through-hole 31 is formed by simultaneously wet-etching both sides of the cover 22, namely the outer side 22a and the inner side 22b. When the cover 22 is viewed from directly above (i.e. when viewed from the direction indicated by arrow "a" in Fig. 4A), the position of the wet-etching on the outer side 22a and the position of the wet-etching on the inner side 22b slightly differ from each other. When the cover 22 is viewed from directly above, a pit formed on the outer side 22a of the cover 22 by the wet-etching (a pit 31a in this example) overlaps a portion of a pit formed on the inner side 22b of the cover 22 by the wet-etching (a pit 31b in this example). The etching is stopped when the pits 31a and 31b connect to each other. As a result, the through-hole 31 in which the pit 31a and the pit 31b connect to each other through a narrow neck 31c in the thickness direction of the cover 22 is formed in the cover 22 as illustrated in Fig. 4A. The diameter of the narrow neck 31c is smaller than the opening diameter φ₁ of the pit 31a and smaller than the opening diameter φ₂ of the pit 31b.

The through-hole 31 does not have a uniform hole diameter and has the narrow neck 31c at its center. The diameter of the narrow neck 31c is smaller than the thickness of the cover 22. Example specific dimensions of the shape illustrated in Fig. 4A are given below.
- Thickness of the cover 22: 0.35 mm
- Diameters of the pits 31a, 31b φ₁, φ₂: 0.4 mm
- Diameter of the narrow neck 31c: φ 0.1 mm

A portion of the cover 22 that is located on the periphery of the opening of the through-hole on the outer side 22a (hereinafter referred to as the outer opening periphery) is melted by irradiation of a laser beam. Arrow "a" in Fig. 4A indicates the laser irradiation direction. The outer opening periphery of the through-hole 31 is a region 22c represented by a dashed line in Fig. 4B. The melted outer opening periphery (hereinafter referred to as melt) moves to the narrow neck 31c (the narrow portion) of the through-hole 31. The narrow neck 31c is closed with the moved melt 22d. The melt 22d solidifies when naturally cooled. As a result, the through-hole 31 is closed.

A sealing hole with a diameter of approximately 0.1 mm is sufficient for allowing gas to pass in and out during the process of hermetic sealing. The narrow neck 31c, which is a sealing hole, can be readily formed by the wet-etching described above. Because the diameter of the sealing hole is small, the sealing hole can be easily closed with the melt resulting from laser beam irradiation.

Because of the melting of the outer opening periphery of the through-hole 31, an enlarged pit 31d with an opening diameter φ₃ greater than the opening diameter φ₁ of the pit 31a before the sealing is formed after the sealing (Fig. 4B). Connection between the pit 31b and the enlarged pit 31d is prevented by a barrier portion. The barrier portion has been formed as a result of solidification of the melt 22d. The thickness of the barrier portion (which is the width of the barrier portion in the thickness direction of the cover 22) is smaller than the thickness of the cover 22. When the cover 22 is viewed from directly above, the pit resulting from melting of the outer opening periphery (the enlarged pit 31d in this example) overlaps the entire barrier portion. In other words, as a result of the laser irradiation, a structure is produced in which the narrow neck 31c narrower than the enlarged opening of the enlarged pit 31d is closed with the barrier portion (i.e. the solidified melt 22d).

### SECOND EMBODIMENT

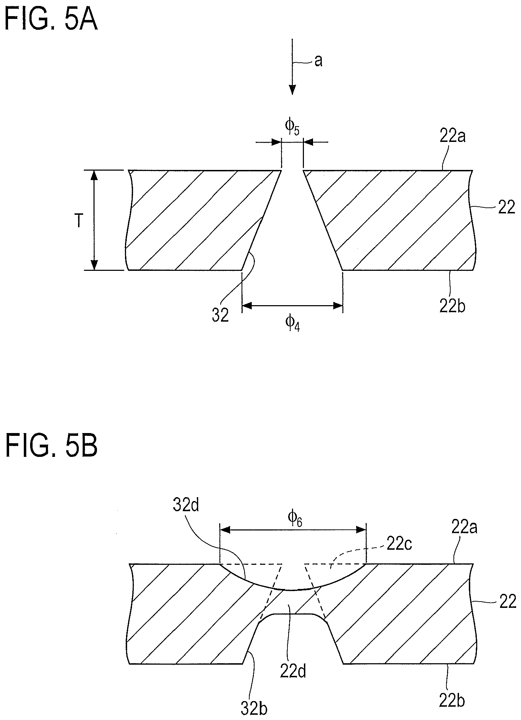

Fig. 5A illustrates a through-hole 32 as a second example. The through-hole 32 is formed by drilling or by laser processing in which the inner side 22b of a cover 22 is irradiated with a laser beam.

The through-hole 32 has a tapered shape. The opening diameter φ₅ of the through-hole 32 on the outer side 22a is smaller than the opening diameter φ₄ of the through-hole 32 on the inner side 22b. The opening of the through-hole 32 on the outer side 22a represents a narrow neck. The opening diameters φ₄ and φ₅ are as follows, for example:
φ ₄ = 0.3 mm, φ₅ = 0.15 mm

The outer opening periphery of the through-hole 32 is melted by irradiation of a laser beam in the direction indicated by arrow "a". The outer opening periphery of the through-hole 32 is the region 22c represented by dashed lines in Fig. 5B. The melted outer opening periphery (i.e. melt) moves into the through-hole 32. A middle portion of the through-hole 32 is closed with the moved melt 22d as illustrated in Fig. 5B. The melt solidifies when naturally cooled. As a result, the through-hole 32 is closed and a pit 32b is formed on the inner side 22b of the through-hole 32.

Because of the melting of the outer opening periphery of the through-hole 32, an enlarged pit 32d with an opening diameter φ₆ greater than the opening diameter φ₅ on the outer side 22a before sealing is formed after the sealing (Fig. 5B). Connection between the pit 32b and the enlarged pit 32d is prevented by a barrier portion. The barrier portion is formed by the melt 22d. The thickness of the barrier portion (which is the width of the barrier portion in the thickness direction of the cover 22) is smaller than the thickness of the cover 22. When the cover 22 is viewed from directly above, the pit (the enlarged pit 32d in this example) resulting from melting of the outer opening periphery overlaps the entire barrier portion. In other words, as a result of the laser irradiation, a structure is produced in which the through-hole 32 is closed by the formation of the barrier portion (i.e. the solidified melt 22d) narrower than the enlarged opening of the enlarged pit 32d.

Taking the cover 22 of the package 20 as an example, a sealing structure provided in the cover 22 has been described above. According to the present invention, a through-hole formed in a package member has been closed after solidification of melt that had been produced from melting of an outer opening periphery and then had moved. In order to provide such a sealing structure, a through-hole is preferable which has a narrow neck and does not have a uniform hole diameter in the direction in which the hole passes. The shape of the through-hole is not limited to the shapes illustrated in Figs. 4A and 5A.

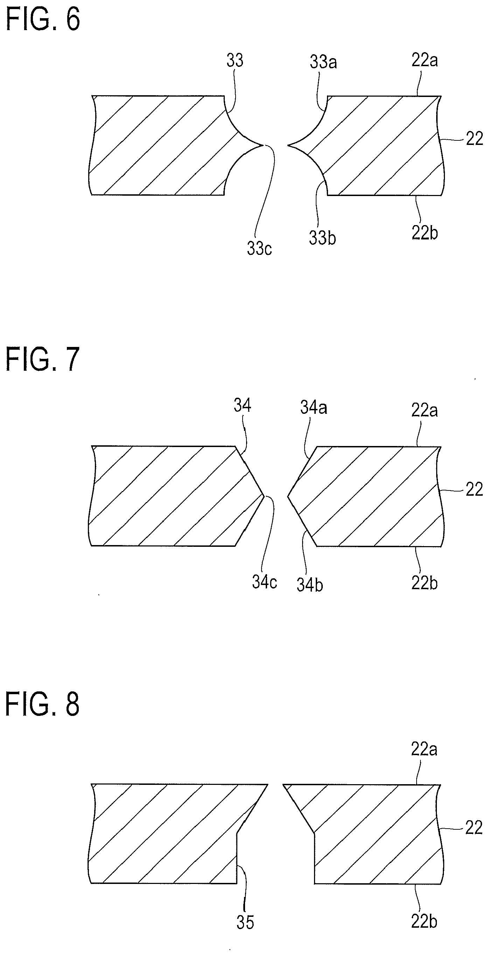

Figs. 6 to 14 illustrate other example shapes of through-holes each of which is formed in a package member (which is a part exposed to the air at least during a sealing process and may be a lid or a sidewall of a package, for example). The shapes of through-holes 33 to 41 illustrated in Figs. 6 to 14 and methods for forming the through-holes 33 to 41 will be described below. In the following description, a cover 22 is taken as an example of the package member.

### THIRD EMBODIMENT

A through-hole 33 is formed by simultaneously wet-etching the outer side 22a and the inner side 22b (Fig. 6). When the cover 22 is viewed from directly above, the location of the wet-etching on the outer side 22a coincides with the location of the wet-etching on the inner side 22b. Pits 33a, 33b are formed by the two-way wet-etching. When the pit 33a and the pit 33b connect to each other, the etching is stopped. As a result, a through-hole 33 in which the pit 33a and the pit 33b connect to each other through a narrow neck 33c in the thickness direction of the cover 22 is formed in the cover 22 as illustrated in Fig. 6.

### FOURTH EMBODIMENT

A through-hole 34 is formed by laser processing (or drilling) of each of the outer side 22a and the inner side 22b (Fig.7). As a result, the through-hole 34 in which a pit 34a and a pit 34b connect to each other through a narrow neck 34c in the thickness direction of the cover 22 is formed as illustrated in Fig. 7.

### FIFTH EMBODIMENT

A through-hole 35 is formed by drilling from the inner side 22b (Fig. 8). When the tip of the drill projects from the outer side 22a, the drilling is stopped. The opening diameter of the through-hole 35 on the inner side 22b is greater than the opening diameter of the through-hole 35 on the outer side 22a. The opening of the through-hole 35 on the outer side 22a represents a narrow neck.

### SIXTH EMBODIMENT

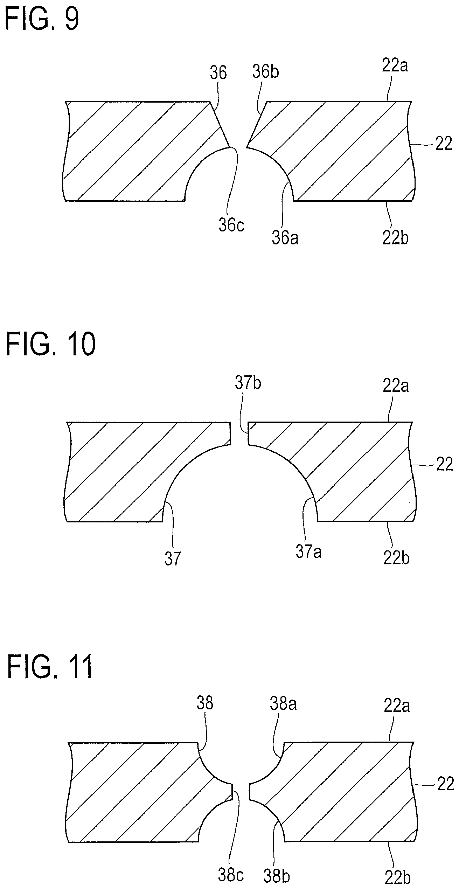

A pit 36a is formed by wet-etching the inner side 22b, then the outer side 22a is laser-processed (or drilled) (Fig. 9). The through-hole 36 has a structure in which a pit 36b formed by laser-processing (or drilling) connects to the pit 36a through a narrow neck 36c.

### SEVENTH EMBODIMENT

A deep pit 37a is formed by wet-etching the inner side 22b, then a drilled hole 37b is formed by drilling (Fig. 10). The through-hole 37 has a structure in which the pit 37a connects to the drilled hole 376b. The hole diameter of the drilled hole 37b is approximately φ 0.1 mm.

### EIGHTH EMBODIMENT

The outer side 22a and the inner side 22b are simultaneously wet-etched to form pits 38a, 38b then drilling is performed to interconnect the pit 38a and the pit 38b. The through-hole 38 has a structure in which the pit 38a connects to the pit 38b through a drilled hole 38c (Fig. 11). The hole diameter of the drilled hole 38c is approximately φ 0.1 mm, for example.

### NINTH EMBODIMENT

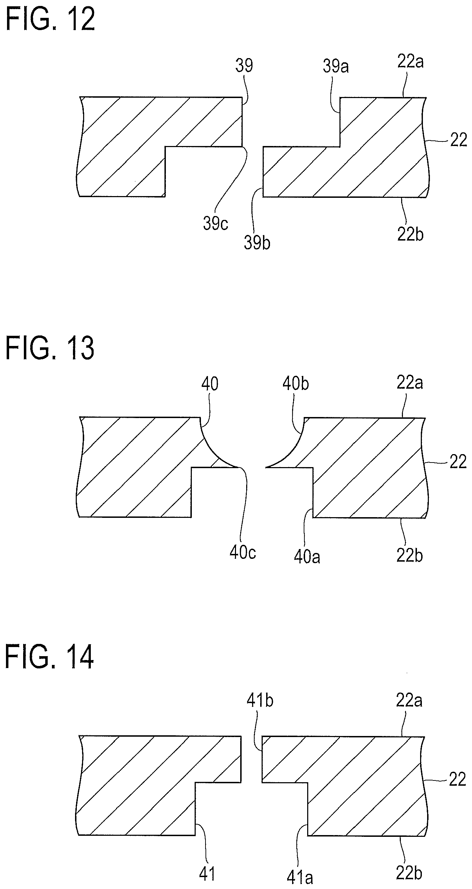

The outer side 22a and the inner side 22b are drilled with a flat-bit drill. When the cover 22 is viewed from directly above, the location of the drilling on the outer side 22a differs from the location of the drilling on the inner side 22b as illustrated in Fig. 12. When the cover 22 is viewed from directly above, a pit 39a formed on the outer side 22a of the cover 22 by the drilling overlaps a portion of a pit 39b formed on the inner side 22b of the cover 22 by the drilling. The through-hole 39 has a structure in which the pit 39a and the pit 39b are interconnected through a narrow neck 39c in the overlapping portion.

### TENTH EMBODIMENT

The inner side 22b is drilled with a flat-bit drill to form a pit 40a and then the outer side 22a is wet-etched. When a pit 40b formed by the wet-etching connects to the pit 40a, the etching is stopped. The through-hole 40 has a structure in which the pit 40a connects to the pit 40b through a narrow neck 40c (Fig. 13).

### ELEVENTH EMBODIMENT

A pit 41a is formed by drilling the inner side 22b with a flat-bit drill, then a drilled hole 41b is formed by drilling with a pointed drill (Fig. 14). The through-hole 41 has a structure in which the pit 41a connects to the drilled hole 41b. The hole diameter of the drilled hole 41b is approximately φ 0.1 mm, for example.

A through-hole having a narrow neck enables easy and good sealing with melt.

Further, the location of a sealing structure in a package is not limited. The material of a package member is not limited to metal and may be ceramic, for example. The means for producing melt is not limited to a laser beam and may be an electronic beam or the like.

The above-described present invention and embodiments thereof will be described from another point of view.

A characteristic common to the present invention and embodiments thereof and the invention described in Patent Literature 1 is that a through-hole is closed by utilizing sedimentation of melt produced from melting of a portion of a package member. In order to close a through-hole by utilizing sedimentation of melt, the melt in liquid form needs to be retained in the through-hole in the sealing process. However, in order to evacuate or interchange gas in the package, the interior of the package and the outside of the package need to be interconnected through the through-hole at the start of the sealing process. Therefore, a narrow neck is required which has such a diameter D that a lump of melt with no holes can remain inside the through-hole due to viscosity, surface tension and the like of the melt and yet evacuation or interchange is not inhibited. It would be best to form a through-hole that has the aforementioned diameter D at any position along the direction in which the through-hole passes, of course. However, that is very difficult and expensive.

In Patent Literature 1, a narrow neck is formed by covering the opening of a through-hole on the inner side with an obstacle (which is a package frame in Patent Literature 1) from the outside. Accordingly, a sealing hole is formed in a location in which the obstacle exists in Patent Literature 1 and the location of the sealing hole therefore cannot arbitrarily be chosen.

In contrast, in the present invention and embodiments thereof, a through-hole itself with a diameter that is not uniform in the direction in which the through-hole passes has a narrow neck. Through-holes can be classified into two types according to the position of the narrow neck formed in the through-holes themselves. In the first type, the narrow neck is located at a middle portion or inner side opening of the through-hole. The first, third, fourth, sixth, eighth, ninth and tenth embodiments are of the first type. In these embodiments, the narrow neck is located in a middle portion of the through-holes. While an embodiment that has a narrow neck at the inner side opening of a through-hole is not illustrated, for example the structure illustrated in Fig. 5A turned upside down represents a structure of this type. In the second type, the narrow neck is located at an outer side opening of the through-hole. The second, fifth, seventh and eleventh embodiments are of the second type.

In the first type, melt resulting from melting of a portion located on the periphery of the outer side opening of the through-hole (outer side opening periphery) moves down along the inner wall of the through-hole and reaches the narrow neck. Because of the hole diameter of the narrow neck described above, the melt remains inside the through-hole and forms a lump of melt that has no holes. By cooling naturally or forcedly the melt in this state, the through-hole is closed.

In the second type, a portion located on the periphery of the outer side opening of the through-hole (outer side opening periphery), that is, the narrow neck itself melts to produce melt. Since the melt is produced at the narrow neck which has the diameter described above, the melt forms a lump that does not have holes in an early stage in the process of moving down along the inner wall of the through-hole, and then slightly moves down and remains inside the through-hole. By cooling naturally or forcedly the melt in this state, the through-hole is closed.

As described above, the inner side openings of the through-holes of both types do not need to be closed with an obstacle from the outer side of the through-hole. Accordingly, the sealing structure can be formed in an arbitrary location in the enclosure part of the package. No additional element, such as a metal ball, is required beside package members, of course.

In an embodiment in which a narrow neck is located at the inner side opening of a through-hole and the hole diameter of the outer side opening is the largest hole diameter of the through-hole, the hole diameter of the outer side opening is further enlarged due to melting of the outer side opening periphery. In other words, a thinner portion is widened. It is therefore preferable that the narrow neck be located at a middle portion or the outer side opening of the through-hole.

The present invention and embodiments thereof based on both types can be summarized as follows.

A package sealing structure of the present invention comprises a structure (hereinafter referred to as the solidified structure) resulting from cooling naturally or forcedly, in a through-hole that is formed in an enclosure part of a package (the enclosure part is a part that is exposed to the air during a sealing process and is, for example, a lid or a sidewall of the package) and has a hole diameter that is not uniform in the direction in which the through-hole passes, melt that had been produced by melting a portion (which is a portion of the enclosure part) located on a periphery of the outer side opening of the through-hole and had formed a lump without holes in the process of moving down along an inner wall of the through-hole. The package sealing structure is further characterized in that the solidified structure is exposed only to gas in the package. The phrase "gas in the package" is not intended to exclude a vacuum produced in the package by evacuation or the like. This is because a perfect vacuum is unrealistic. Further, the through-hole preferably has a narrow neck located at a middle portion or outer side opening of the through-hole (in other words, the narrow neck is located in a region other than the inner side opening of the through-hole).

In another aspect, a product (a package sealing structure) according to the present invention may be described by a process as described above. The product according to the present invention may have any of various structures depending on the viscosity and surface tension of melt, the shape of a through-hole and the like. Accordingly, the product according to the present invention can be defined only by process steps or process steps impart distinctive structural characteristics to the product according to the present invention.

However, in terms of product, the package sealing structure of the present invention is not the same as the package sealing structure disclosed in Patent Literature 1, for example. In the package sealing structure disclosed in Patent Literature 1, the melt has a structure that has solidified after contacting an obstacle. In contrast, in the structure of the product of the present invention implied by the process, the melt has a structure that has solidified without contacting an obstacle.

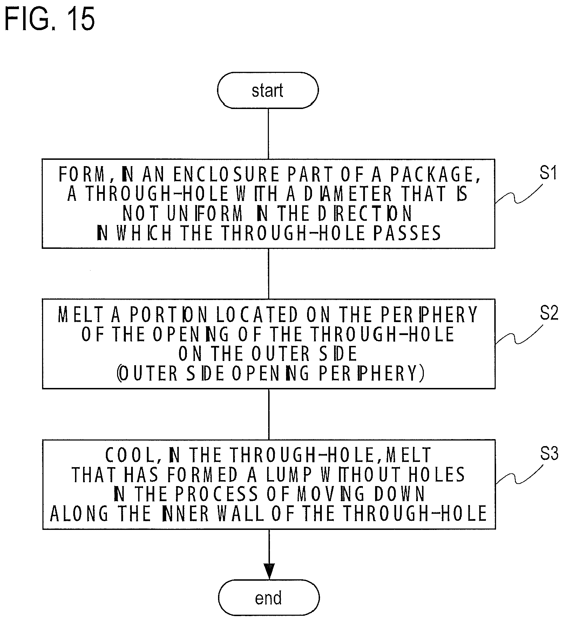

A package sealing method according to the present invention comprises: (1) step S1 of forming a through-hole having a hole diameter that is not uniform in the direction in which the through-hole passes in an enclosure part of a package (a part that is exposed to the air at least during a sealing process and is, for example, a lid or inner wall of the package); (2) step S2 of melting a portion (which is a portion of the enclosure part) located on a periphery of an outer side opening of the through-hole; and (3) step S3 of cooling naturally or forcedly, in the through-hole, melt that has been produced in step S2 and has formed a lump without holes in the process of moving down along an inner wall of the through-hole (see Fig. 15). The package sealing method is further characterized in that the through-hole formed in step S1 preferably comprises a narrow neck located at a middle potion or outer side opening of the through-hole (in other words, the narrow neck is located in a region other than the inner side opening of the through-hole).

The foregoing description of the embodiments of the invention has been presented for the purpose of illustration and description. It is not intended to be exhaustive and to limit the invention to the precise form disclosed. Modifications or variations are possible in light of the above teaching. The embodiments were chosen and described to provide the best illustration of the principles of the invention and its practical application, and to enable one of ordinary skill in the art to utilize the invention in various embodiments and with various modifications as are suited to the particular use contemplated. All such modifications and variations are within the scope of the invention as determined by the appended claims when interpreted in accordance with the breadth to which they are fairly, legally, and equitably entitled.

## Claims

1. A package sealing structure, wherein a narrow neck of a through-hole formed in a package member is closed with a substance that has been produced from melting of an outer side of the package member and then has solidified, and the narrow neck is narrower than an opening of the through-hole that has been enlarged by the melting.

2. The package sealing structure according to claim 1, wherein the narrow neck has a diameter smaller than the thickness of the package member.

3. The package sealing structure according to claim 1 or 2, wherein the package member is made of metal.

4. A device package comprising the package sealing structure according to any of claims 1 to 3.

5. A package sealing structure comprising a structure resulting from cooling, in a through-hole which had been formed in an enclosure part of a package and had had a hole diameter not uniform in a through direction of the thorough-hole, melt that had been produced from melting of a portion located on a periphery of an outer side opening of the through-hole and had formed a lump without holes in the process of moving down along an inner wall of the through-hole.

6. A package sealing method comprising:
forming, in an enclosure part of a package, a through-hole having a hole diameter not uniform in a through direction of the thorough-hole;
melting a portion located on a periphery of an outer side opening of the through-hole; and
cooling, in the through-hole, melt that has produced in the melting of the portion and has formed a lump without holes in the process of moving down along an inner wall of the through-hole.
